# EUROPEAN PATENT APPLICATION

(11) **EP 4 761 547 A1**
(43) Date of publication of application: **17.06.2026**
(21) Application number: 25210127.4
(22) Date of filing: 21.10.2025
(51) Int. Cl.: H10K 59/80, H10K 59/38

(54) **DISPLAY APPARATUS**

(30) Priority: 16.12.2024 KR 20240187768
(71) Applicant: LG Display Co., Ltd., Seoul, 07336 (KR)
(72) Inventor: KIM, Seungkyeom, 10845 Paju-si, Gyeonggi-do (KR); PARK, Hyemin, 10845 Paju-si, Gyeonggi-do (KR); KIM, Taehyeon, 10845 Paju-si, Gyeonggi-do (KR)
(74) Representative: Viering, Jentschura & Partner mbB Patent- und Rechtsanwälte

(57) **Abstract**

A display apparatus (100) comprising: a substrate (110) comprising a plurality of pixels having a plurality of subpixels (SP), wherein a first subpixel (SP1) of the plurality of subpixels (SP) comprises: an overcoat layer (113) disposed on the substrate (110); an upper color filter (UCF) on the overcoat layer (113); a pixel electrode (114) disposed on the upper color filter (UCF); and a reflective electrode (117) on the pixel electrode (114), wherein the reflective electrode (117) extends into a non-light emission area (NEA) between the plurality of subpixels (SP), the reflective electrode (117) in the non-light emission area (NEA) is partially disposed closer to the substrate (110) than the pixel electrode (114), and a refractive index of the upper color filter (UCF) is different from a refractive index of the overcoat layer (113).

## Description

### BACKGROUND

### Field of the Invention

The present disclosure relates to a display apparatus for displaying images.

### Discussion of the Related Art

Since an organic light emitting display apparatus has a high response speed and low power consumption and self-emits light without requiring a separate light source unlike a liquid crystal display apparatus, there is no problem in a viewing angle and thus the organic light emitting display apparatus has received attention as a next-generation flat panel display apparatus.

Such a display apparatus displays an image through light emission of a light emitting element layer that includes a light emitting layer interposed between two electrodes.

There exists a need to improve the light extraction efficiency of the display apparatus.

### SUMMARY

An aspect of the present disclosure is directed to providing a display apparatus in which a light extraction efficiency of light emitted from a subpixel may be improved.

Further, an aspect of the present disclosure is directed to providing a display apparatus capable of maximizing light extraction efficiency.

Further, an aspect of the present disclosure is directed to providing a display apparatus in which overall power consumption may be reduced through light extraction from a light emission area and/or a non-light emission area.

The problems to be solved by the examples of the present disclosure are not limited to those mentioned above, and other problems not mentioned will be apparent to one of ordinary skill in the art to which the technical spirits of the present disclosure belong from the following description.

A display apparatus according to an aspect of the present disclosure comprises: a substrate comprising a plurality of pixels having a plurality of subpixels, wherein a first subpixel of the plurality of subpixels comprises: an overcoat layer disposed on the substrate; an upper color filter on the overcoat layer; a pixel electrode disposed on the upper color filter; and a reflective electrode on the pixel electrode, wherein the reflective electrode extends into a non-light emission area between the plurality of subpixels, the reflective electrode in the non-light emission area is partially disposed closer to the substrate than the pixel electrode, and a refractive index of the upper color filter is different from a refractive index of the overcoat layer. Further embodiments are described in the dependent claims.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a schematic plan view of a display apparatus according to one embodiment of the present disclosure.
FIG. 2 is a schematic plan view of one pixel illustrated in FIG. 1.
FIG. 3 is a schematic cross-sectional view of the line I-I' shown in FIG. 2.
FIG. 4 is a schematic cross-sectional view of the line II-II' shown in FIG. 2.
FIG. 5 is a schematic cross-sectional view of a display apparatus according to the second embodiment of the present disclosure.
FIG. 6 is a schematic cross-sectional view taken along line III-III' of FIG. 2, showing a display apparatus according to the third embodiment of the present disclosure.
FIG. 7 is a schematic cross-sectional view of a display apparatus according to the fourth embodiment of the present disclosure.
FIG. 8 is an enlarged view of part A of FIG. 7.
FIG. 9 is a schematic cross-sectional view of a display apparatus according to the fifth embodiment of the present disclosure.

### DETAILED DESCRIPTION OF THE DISCLOSURE

Reference will now be made in detail to the embodiments of the present disclosure, examples of which are illustrated in the accompanying drawings. Wherever possible, the same reference numbers will be used throughout the drawings to refer to the same or like parts. Advantages and features of the present disclosure, and implementation methods thereof will be clarified through following embodiments described with reference to the accompanying drawings.

The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present disclosure are used, another part may be added unless 'only~' is used. The terms of a singular form may include plural forms unless referred to the contrary.

In construing an element, the element is construed as including an error range although there is no explicit description.

In describing a position relationship, for example, when a position relation between two parts is described as 'on~', 'over~', 'under~', and 'next~', one or more other parts may be disposed between the two parts unless 'just' or 'direct' is used.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms.

These terms are only used to distinguish one element from another. For example, a first element could be termed a second element, and, similarly, a second element could be termed a first element, without departing from the scope of the present disclosure.

"X-axis direction", "Y-axis direction" and "Z-axis direction" should not be construed by a geometric relation only of a mutual vertical relation and may have broader directionality within the range that elements of the present disclosure may act functionally.

The term "at least one" should be understood as including any and all combinations of one or more of the associated listed items. For example, the meaning of "at least one of a first item, a second item and a third item" denotes the combination of all items proposed from two or more of the first item, the second item and the third item as well as the first item, the second item or the third item.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in co-dependent relationship.

Hereinafter, the preferred embodiments of the present disclosure will be described in detail with reference to the accompanying drawings.

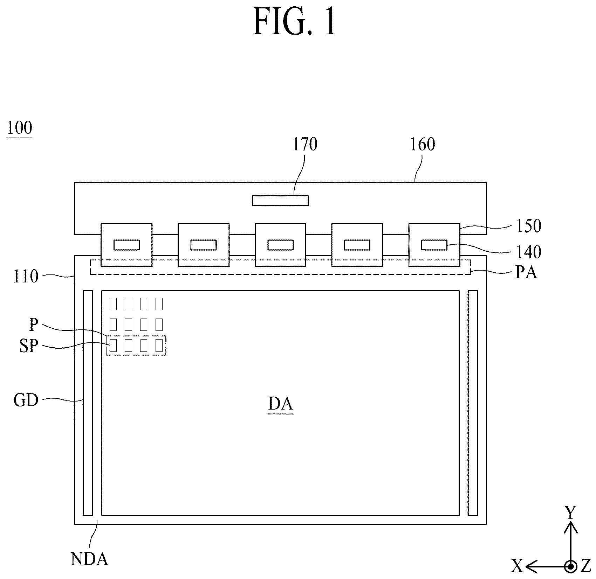

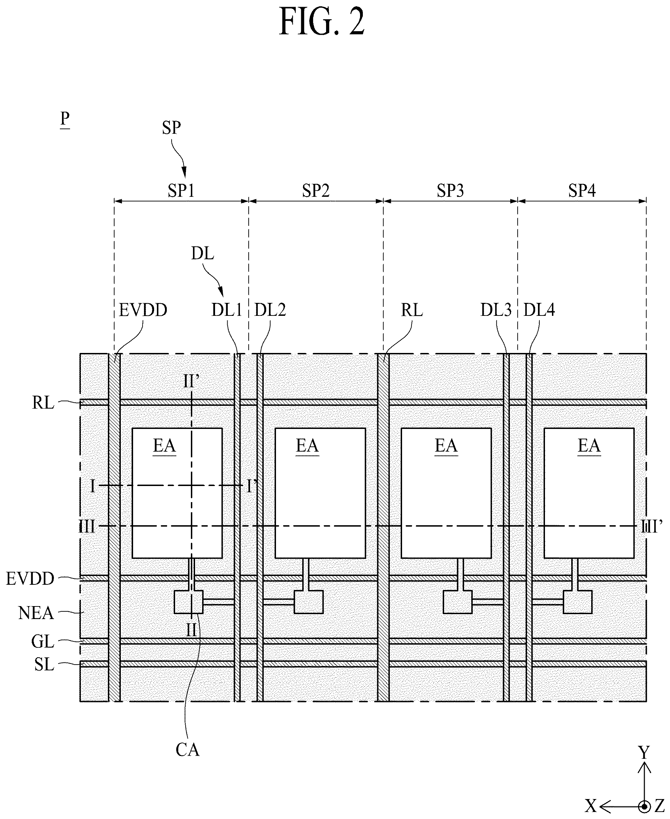

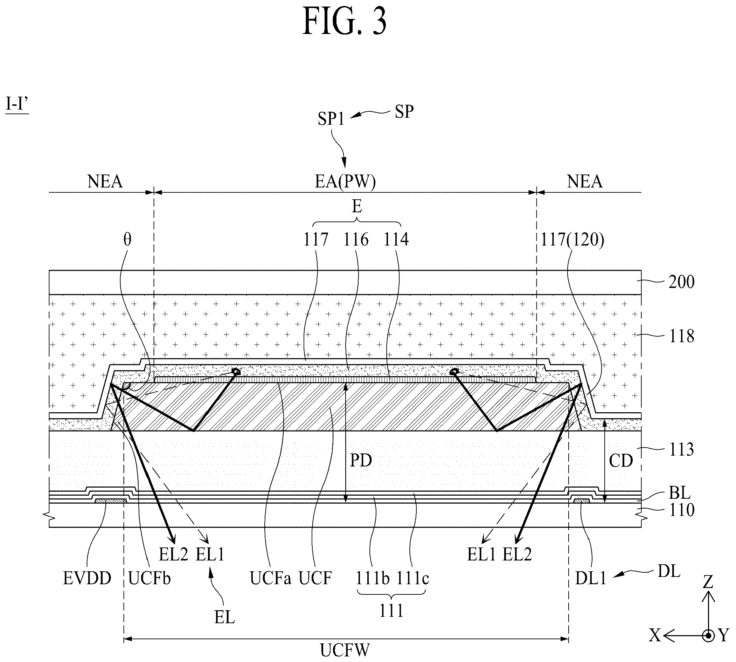

FIG. 1 is a schematic plan view of a display apparatus according to one embodiment of the present disclosure, FIG. 2 is a schematic plan view of one pixel illustrated in FIG. 1, and FIG. 3 is a schematic cross-sectional view of the line I-I' shown in FIG. 2.

Referring now to FIGS. 1 to 3, a display apparatus 100 according to one embodiment of the present disclosure may include a substrate 110 including a plurality of pixels including a plurality of sub-pixels SP. One of the plurality of subpixels SP (e.g., a first subpixel SP1) may include an overcoat layer 113, an upper color filter UCF, a pixel electrode 114, and a reflective electrode 117.

The overcoat layer 113 according to one example may be disposed on the substrate 110. The upper color filter UCF according to one example may be disposed on the overcoat layer 113. The pixel electrode 114 according to one example may be disposed on the upper color filter UCF. The reflective electrode 117 according to one example may be disposed on the pixel electrode 114.

As shown in FIG. 3, the reflective electrode 117 extends to a non-light emission area NEA between the plurality of subpixels SP, and the reflective electrode 117 in the non- light emission area NEA can be partially positioned closer to the substrate 110 than the pixel electrode 114. According to one example, the pixel electrode 114 may be arranged spaced apart from the upper surface of the substrate 110 by a first distance PD. For example, the first distance PD may be a distance that is a sum of a thickness of the upper color filter UCF, a thickness of the overcoat layer 113, a thickness of a plurality of inorganic film layers 111, and a thickness of a buffer layer BL. In contrast, the reflective electrode 117 located closest to the substrate 110 among the reflective electrodes 117 in the non-light emission area NEA may be located at a second distance CD shorter than the first distance PD from the upper surface of the substrate 110. For example, the second distance CD may be a distance obtained by subtracting the thickness of the upper color filter UCF from the first distance PD and adding a thickness of an organic light-emitting layer 116.

In the above, the reflective electrode 117 located closest to the substrate 110 among the reflective electrodes 117 in the non-light emission area NEA was described as one example, but is not limited thereto. The reflective electrode 117 in the non-light emission area NEA is positioned closer to the substrate 110 than the pixel electrode 114 in the light emission area EA and may include a reflective electrode 117 that is positioned obliquely. Hereinafter, the reflective electrode 117 that is positioned obliquely in the non-light emission area NEA is defined as a reflective portion 120.

As shown in FIG. 3, the reflective portion 120 according to one example is arranged obliquely in the non-light emission area NEA, so that light emitted from the organic light-emitting layer 116 and directed toward an adjacent subpixel SP can be reflected toward the emitting subpixel SP. Accordingly, light emitted from one subpixel (e.g., the first subpixel SP1) and directed toward the adjacent subpixel is reflected by the reflective portion 120 and directed toward the emitting subpixel, i.e., the first subpixel SP1, and can be emitted to the outside of the substrate 110. Accordingly, in the display apparatus 100 according to one embodiment of the present disclosure, the reflective electrode 117 (or reflective portion 120) positioned closer to the substrate 110 than the pixel electrode 114 in the non-light emission area NEA can reflect light emitted from one subpixel (e.g., the first subpixel SP1) toward the adjacent subpixel, thereby improving light extraction efficiency.

Additionally, in the display apparatus 100 according to one embodiment of the present disclosure, a refractive index of the upper color filter UCF may be provided differently from a refractive index of the overcoat layer 113. For example, the refractive index of the upper color filter UCF may be provided greater than the refractive index of the overcoat layer 113. Accordingly, some of the light emitted from one subpixel (e.g., the first subpixel SP1) may be totally reflected at the interface between the upper color filter UCF and the overcoat layer 113 to form an optical path to the reflective electrode 117 in the non-light emission area NEA.

For example, some of the light emitted from one subpixel (e.g., the first subpixel SP1) may be totally reflected due to the difference in refractive index between the upper color filter UCF and the overcoat layer 113. Light that is totally reflected at the interface between the upper color filter UCF and the overcoat layer 113 and is incident on the reflective electrode 117 (or reflective portion 120) of the non-light emission area NEA is reflected by the reflective electrode 117 (or reflective portion 120) and directed toward the light-emitting subpixel, i.e., the first subpixel SP1, and can be emitted to the outside of the substrate 110.

Therefore, in the display apparatus 100 according to one embodiment of the present disclosure, since a reflective electrode 117 included in one subpixel (e.g., the first subpixel SP1) among a plurality of subpixels SP is partially positioned closer to the substrate 110 than the pixel electrode 114 in the non-light emission area NEA, light directed toward an adjacent subpixel can be reflected to an outside of the substrate 110 by changing the direction of the light toward the subpixel (e.g., the first subpixel SP1) where the reflective electrode 117 emits light, thereby further improving the light extraction efficiency.

As a result, the display apparatus 100 according to the present disclosure can improve light extraction efficiency because the reflective electrode 117 positioned closer to the substrate 110 than the pixel electrode 114 in the non-light emission area NEA can reflect light emitted from one subpixel (e.g., the first subpixel SP1) toward the adjacent subpixel to the emitting subpixel (e.g., the first subpixel SP1). In addition, the display apparatus 100 according to the present disclosure is provided such that the overcoat layer 113 and the color filter (or upper color filter UCF) included in one of the plurality of subpixels (for example, the first subpixel SP1) have different refractive indices, so that the light extraction efficiency can be maximized through total reflection at the interface between the overcoat layer 113 and the color filter (or upper color filter UCF).

Meanwhile, in the present disclosure, light, which is emitted from the subpixel (e.g., the first subpixel SP1) (or the organic light-emitting layer 116 on the pixel electrode 114) and is incident on a reflective electrode 117 arranged in the non-light emission area NEA through various paths, and then reflected by the reflective electrode 117 and emitted to the outside of the substrate 110, is defined as a reflected light EL.

As shown in FIG. 3, the reflected light EL according to one example may include a direct reflected light EL1 and an indirect reflected light EL2. The direct reflection light EL1 may mean light emitted from the light-emission area EA on the pixel electrode 114 that is not totally reflected at another interface but is directly reflected by the reflective electrode 117 (or reflective portion 120) that is obliquely arranged in the non-light emission area NEA and emitted to the outside of the substrate 110. The indirect reflected light EL2 may mean light emitted from the light-emission area EA on the pixel electrode 114 that is first totally reflected at the interface between the upper color filter UCF and the overcoat layer 113 and then secondarily reflected by the reflective electrode 117 (or reflective portion 120) that is obliquely arranged in the non-light emission area NEA and then emitted to the outside of the substrate 110. The indirectly reflected light EL2 emitted from the display apparatus 100 according to one embodiment of the present disclosure is light that is totally reflected inside the substrate 110 and emitted to the outside of the substrate 110, and therefore can be expressed in terms of a substrate mode emitted light.

As a result, the display apparatus 100 according to one embodiment of the present disclosure is provided such that the reflective electrode 117 in the non-light emission area NEA is partially positioned closer to the substrate 110 than the pixel electrode 114, so that light directed to an adjacent subpixel can be emitted outside the substrate 110 in the form of the direct reflected light EL1 and/or the indirect reflected light EL2, thereby improving light extraction efficiency.

Referring to FIG. 3, in the display apparatus 100 according to one embodiment of the present disclosure, a width PW of the pixel electrode 114 may be provided to be equal to or narrower than a width UCFW of an upper surface UCFa of the upper color filter UCF. If the width PW of the pixel electrode 114 is provided to be greater than the width UCFW of the upper surface UCFa of the upper color filter UCF, the pixel electrode 114 can be arranged to extend to a side surface UCFb of the upper color filter UCF, and thus light emission can also occur at the side surface UCFb of the upper color filter UCF. When light is emitted from the side surface UCFb of the upper color filter UCF, color mixing may occur because light may be emitted to adjacent subpixels. Accordingly, the display apparatus 100 according to one embodiment of the present disclosure can prevent color mixing between subpixels by providing the width PW of the pixel electrode 114 to be equal to or narrower than the width UCFW of the upper surface UCFa of the upper color filter UCF.

For example, as shown in FIG. 3, when the width PW of the pixel electrode 114 is provided narrower than the width UCFW of the upper surface UCFa of the upper color filter UCF, a process margin of the pixel electrode 114 with respect to the upper surface UCFa of the upper color filter UCF is sufficient, so that the defect rate of the display apparatus can be reduced. As another example, when the width PW of the pixel electrode 114 is provided to be equal to the width UCFW of the upper surface UCFa of the upper color filter UCF, a width of the light-emission area EA can be wider than when the width PW of the pixel electrode 114 is provided to be narrower than the width UCFW of the upper surface UCFa of the upper color filter UCF, so that the light efficiency can be further improved.

Hereinafter, the display apparatus 100 according to one embodiment of the present disclosure will be examined in more detail with reference to FIGS. 1 and 2.

Referring to FIGS. 1 and 2, the display apparatus 100 according to one embodiment of the present disclosure may include a display panel having a gate driver GD, a source drive integrated circuit (hereinafter, referred to as "IC") 140, a flexible film 150, a circuit board 160, and a timing controller 170.

The display panel may include a substrate 110 and an opposite substrate 200 (shown in FIG. 3).

The substrate 110 may include a thin film transistor, and may be a transistor array substrate, a lower substrate, a base substrate, or a first substrate. The substrate 110 may be a transparent glass substrate or a transparent plastic substrate. The substrate 110 may include a display area DA and a non-display area NDA.

The display area DA is an area where an image is displayed, and may be a pixel array area, an active area, a pixel array unit, a display unit, or a screen. For example, the display area DA may be disposed at a central portion of the display panel. The display area DA may include a plurality of pixels P.

The opposite substrate 200 may encapsulate (or seal) the display area DA disposed on the substrate 110. For example, the opposite substrate 200 may be bonded to the substrate 110 via an adhesive member (or clear glue). The opposite substrate 200 may be an upper substrate, a second substrate, or an encapsulation substrate. The opposite substrate 200 may comprise a metal layer that is magnetic, such as Invar, SUS, or the like. Alternatively, the opposite substrate 200 may be composed of multiple layers, such as a metal layer for good heat dissipation, such as Aluminum, an organic adhesive layer for adhesion, and an organic protective layer that is thicker than the metal layer for improved encapsulating performance.

The gate driver GD supplies gate signals to the gate lines in accordance with the gate control signal input from the timing controller 180. The gate driver GD may be formed on one side of the light emission area EA or in the non-light emission area NEA outside both sides of the light emission area EA in a gate driver in panel (GIP) method, as shown in FIG. 1.

The non-display area NDA is an area on which an image is not displayed, and may be a peripheral area, a signal supply area, an inactive area or a bezel area. The non-display area NDA may be configured to be in the vicinity of the display area DA. That is, the non-display area NDA may be disposed to surround the display area DA.

A pad area PA may be disposed in the non-display area NDA. The pad area PA may supply a power source and/or a signal for outputting an image to the pixel P provided in the display area DA. Referring to FIG. 1, the pad area PA may be provided above the display area DA.

The source drive IC 140 receives digital video data and a source control signal from the timing controller 170. The source drive IC 140 converts the digital video data into analog data voltages in accordance with the source control signal and supplies the analog data voltages to the data lines. When the source drive IC 140 is manufactured as a driving chip, the source drive IC 140 may be packaged in the flexible film 150 in a chip on film (COF) method or a chip on plastic (COP) method.

Pads, such as data pads, may be formed in the non-display area NDA of the display panel. Lines connecting the pads with the source drive IC 140 and lines connecting the pads with lines of the circuit board 160 may be formed in the flexible film 150. The flexible film 150 may be attached onto the pads by using an anisotropic conducting film, whereby the pads may be connected with the lines of the flexible film 150.

The circuit board 160 may be attached to the flexible films 150. A plurality of circuits implemented as driving chips may be packaged in the circuit board 160. For example, the timing controller 170 may be packaged in the circuit board 160. The circuit board 160 may be a printed circuit board or a flexible printed circuit board.

The timing controller 170 receives the digital video data and a timing signal from an external system board through a cable of the circuit board 160. The timing controller 170 generates a gate control signal for controlling an operation timing of the gate driver GD and a source control signal for controlling the source drive ICs 140 based on the timing signal. The timing controller 170 supplies the gate control signal to the gate driver GD, and supplies the source control signal to the source drive ICs 140.

Referring to FIGS. 2 and 3, the substrate 110 according to an example may include the light emission area EA and the non-light emission area NEA.

The light emission area EA may mean an area from which light is emitted. A light emitting element layer E, which includes a pixel electrode 114, an organic light emitting layer 116 and a reflective electrode 117, may be disposed in the light emission area EA. When an electric field is formed between the pixel electrode 114 and the reflective electrode 117, the organic light emitting layer 116 in the light emission area EA may be emitted. The light emission area EA may overlap with an area in which the pixel electrode 114, the organic light emitting layer 116, and the reflective electrode 117 are in contact with each other. The non-light emission area NEA may refer to an area from which light is not emitted and that surrounds the light emission area EA.

As shown in FIG. 3, some of the light emitted from the organic light-emitting layer 116 may form a light path toward an adjacent subpixel (or a non-emitting subpixel). The display apparatus 100 according to one embodiment of the present disclosure can reflect light directed to the adjacent subpixel to the non-light emission area NEA or light emission area EA of the emitting subpixel by arranging the reflective portion 120 between subpixels SP (or in the non-light emission area NEA). Accordingly, the display apparatus 100 according to one embodiment of the present disclosure can improve the light efficiency of a light-emitting subpixel by extracting light directed toward the adjacent subpixel by the light reflective portion 120. In addition, the display apparatus 100 according to one embodiment of the present disclosure can prevent color mixing due to the reflective portion 120 disposed between the subpixels SP.

Referring back to FIG. 2, the light emission area EA according to an example may include gate lines, data lines, pixel driving power lines, and a plurality of pixels P. Each of the plurality of pixels P may include a plurality of subpixels SP that may be defined by the gate lines and the data lines.

At least four subpixels, which are provided to emit different colors and disposed to be adjacent to one another, among the plurality of subpixels SP may constitute one pixel P (or unit pixel). One pixel P may include, but is not limited to, a red subpixel, a white subpixel, a blue subpixel and a green subpixel. One pixel P may include three subpixels SP provided to emit light of different colors and disposed to be adjacent to one another. For example, one pixel P may include a red subpixel, a green subpixel and a blue subpixel.

Each of the plurality of subpixels SP includes a thin film transistor and a light emitting element layer E connected to the thin film transistor. Each of the plurality of subpixels may include a light emitting layer (or an organic light emitting layer) interposed between the pixel electrode and the reflective electrode.

The light emitting layers disposed in each of the plurality of sub-pixels SP may emit white light in common. Since the light emitting layer of each of the plurality of sub-pixels SP emits white light in common, each of the red sub-pixel, the green sub-pixel, and the blue sub-pixel may include a color filter CF (or wavelength conversion member CF) that converts the white light to the respective colored light. In this case, the white sub-pixel may not comprise a color filter.

In the display apparatus 100 according to one embodiment of the present disclosure, the area with the red color filter may be a red sub-pixel or a first sub-pixel or one subpixel, the area without the color filter may be a white sub-pixel or a second sub-pixel or another subpixel, the area with the blue color filter may be a blue sub-pixel or a third sub-pixel or another subpixel, and the area with the green color filter may be a green sub-pixel or a fourth sub-pixel. The area equipped with the green color filter has the same structure as the red subpixel except that the color of the color filter is different from that of the area equipped with the red color filter, so it can be expressed as one subpixel. Therefore, in this disclosure, one subpixel may mean the red subpixel (or the first subpixel SP1) or the green subpixel (or the fourth subpixel SP4). When one unit pixel P of the display apparatus 100 according to one embodiment of the present disclosure includes four subpixels, the four subpixels may mean the red subpixel (or the first subpixel SP1), the white subpixel (or the second subpixel SP2), the blue subpixel (or the third subpixel SP3), and the green subpixel (or the fourth subpixel SP4).

Each of the subpixels SP supplies a predetermined current to the organic light emitting element in accordance with a data voltage of the data line when a gate signal is input from the gate line by using the thin film transistor. For this reason, the light emitting layer of each of the subpixels may emit light with a predetermined brightness in accordance with the predetermined current.

The plurality of subpixels SP according to one example may be disposed to be adjacent to each other in a first direction (X-axis direction).

The plurality of subpixels SP may include the first subpixel SP1 (or one subpixel), the second subpixel SP2 (or another subpixel), the third subpixel SP3 (or another subpixel), and the fourth subpixel SP4 that are arranged adjacent to each other in the first direction (X-axis direction). For example, the first subpixel SP1 can be the red subpixel, the second subpixel SP2 can be the white subpixel, the third subpixel SP3 can be the blue subpixel, and the fourth subpixel SP4 can be the green subpixel. However, it is not necessarily limited to this, and the arrangement order of the first subpixel SP1, the second subpixel SP2, the third subpixel SP3, and the fourth subpixel SP4 may be changed.

Each of the first to fourth subpixels SP1 to SP4 may include a light emission area EA and a circuit area CA. The light emission area EA may be disposed at one side (or an upper side) of a subpixel area, and the circuit area CA may be disposed at the other side (or a lower side) of the subpixel area. For example, the circuit area CA may be disposed at one side (or the lower side) of the light emission area EA based on the second direction (Y-axis direction). The light emission area EA of each of the first to fourth sub-pixels SP1 to SP4 may have the same size (or area) or different sizes (or areas) from each other.

The first to fourth subpixels SP1 to SP4 may be disposed to be adjacent to one another along the first direction (X-axis direction). For example, two data lines DL extending along the second direction (Y-axis direction) may be disposed in parallel with each other between the first subpixel SP1 and the second subpixel SP2 and between the third subpixel SP3 and the fourth subpixel SP4. A pixel power line EVDD (or branch wiring of the pixel power line) extending along the first direction (X-axis direction) may be disposed between the light emission area EA and the circuit area CA of each of the first to fourth subpixels SP1 to SP4. The gate line GL and a sensing line SL may be disposed below the circuit area CA. The pixel power line EVDD (shown in FIG. 2) extending along the second direction (Y-axis direction) may be disposed at one side of the first subpixel SP1 or the fourth subpixel SP4. A reference line RL extending along the second direction (Y-axis direction) may be disposed between the second subpixel SP2 and the third subpixel SP3. The reference line RL may be used as a sensing line for sensing a change of characteristics of a driving thin film transistor and/or a change of characteristics of the light emitting element layer, which is disposed in the circuit area, from the outside in a sensing driving mode of the pixel P. In one example, the data lines DL are for supplying data signals to each of the plurality of the sub-pixels SP to drive each of the plurality of the sub-pixels SP. For example, the data lines DL may include a first data line DL1 for driving a first sub-pixel SP1, a second data line DL2 for driving a second sub-pixel SP2, a third data line DL3 for driving a third sub-pixel SP3, and a fourth data line DL4 for driving a fourth sub-pixel SP4.

In the display apparatus 100 according to one embodiment of the present disclosure, the data lines may be disposed not to overlap the light emission area EA. For example, the first data line DL1 may be arranged such that it does not overlap the light emission area EA. Thus, in the display apparatus 100 according to one embodiment of the present disclosure, the first data line DL1 does not overlap (or is not interfered with) light emitted from the light emission area EA, thus a decrease in light extraction efficiency may be prevented. The second data line DL2, the third data line DL3, and the fourth data line DL4, like the first data line DL1, may be disposed in the non-light emission area NEA of the corresponding sub-pixel so as not to be overlapped the light emission area EA of the corresponding sub-pixel in the third direction (Z-axis direction). Thus, in the display apparatus 100 according to one embodiment of the present disclosure, the data lines DL1, DL2, DL3, DL4 may have a structural feature that do not overlap the light emission area EA but overlap the non-light emission area NEA.

On the other hand, each of the pixel power line EVDD and the reference line RL may be disposed in the non-light emission area NEA so as not to obscure (or interfere with) light emitted from the light emission area EA, such as the data lines described above.

In the display apparatus 100 according to one embodiment of the present disclosure, each of the plurality of the sub-pixels SP may include the light emission area EA disposed adjacent to the non-light emission area NEA. As shown in FIG. 3, the reflective portion 120 may be spaced apart from the light emission area EA. This is because if the reflective portion 120 is not spaced apart from the light emission area and is disposed adjacent to the light emission area or overlapped with the light emission area, the light emitted from the light emission area EA is not able to be reflected by the reflective portion 120.

Thus, in the display apparatus 100 according to one embodiment of the present disclosure, the reflective portion 120 is spaced apart from the light emission area EA, such that light directed to an adjacent sub-pixel (e.g., the second sub-pixel SP2) among the light emitted from the light emission area EA may be reflected by the reflective portion 120, thereby improving light extraction efficiency. As illustrated in FIG. 3, since the light-emission area EA is an area defined by the pixel electrode 114 positioned on the upper color filter UCF, the reflective portion 120 positioned in the non-light-emission area NEA can be positioned apart from the pixel electrode 114.

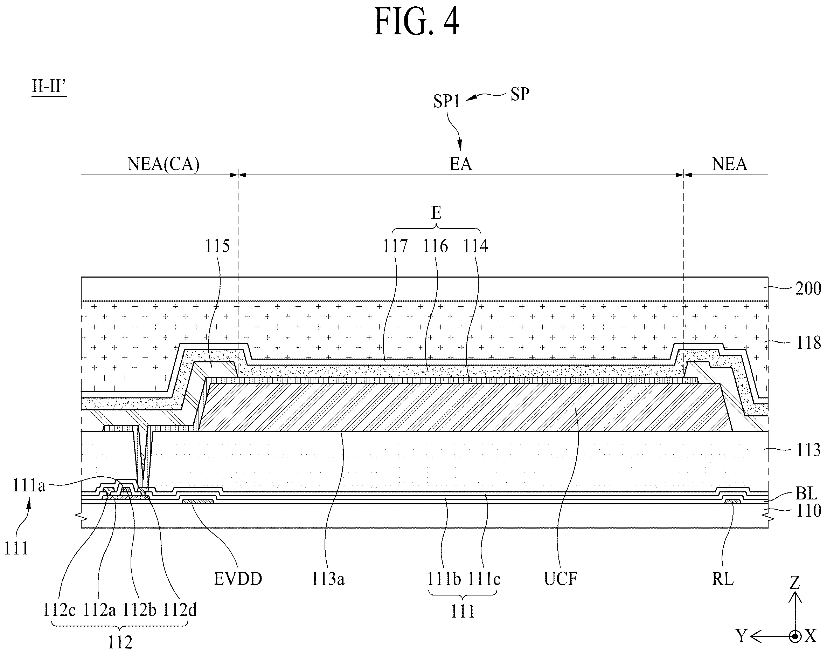

Hereinafter, referring to FIG. 4, a structure of each of the plurality of subpixels SP will be described in detail.

FIG. 4 is a schematic cross-sectional view of the line II-II' shown in FIG. 2.

Referring to FIG. 4, the display apparatus 100 according to one embodiment of the present disclosure may further include a buffer layer BL, a circuit element layer 111, a thin film transistor 112, an overcoat layer 113, an upper color filter UCF, a pixel electrode 114, a bank 115, an organic light emitting layer 116, a reflective electrode 117, and an encapsulation layer 118.

In more detail, one of the plurality of subpixels SP (e.g., the first subpixel SP1) may include a circuit element layer 111 provided on an upper surface of a buffer layer BL, including a gate insulating layer 111a, an interlayer insulating layer 111b and a passivation layer 111c, an overcoat layer 113 provided on the circuit element layer 111, the upper color filter UCF provided on the overcoat layer 113, a pixel electrode 114 provided on the upper color filter UCF, a bank 115 covering an edge of the pixel electrode 114, an organic light emitting layer 116 on the pixel electrode 114 and the bank 115, a reflective electrode 117 on the organic light emitting layer 116, and an encapsulation layer 118 on the reflective electrode 117.

The thin film transistor 112 for driving the subpixel SP may be disposed on the circuit element layer 111. The circuit element layer 111 may be expressed as the term of an inorganic film layer. The buffer layer BL may be included in the circuit element layer 111 together with the gate insulating layer 111a, the interlayer insulating layer 111b and the passivation layer 111c. The pixel electrode 114, the organic light emitting layer 116 and the reflective electrode 117 may be included in the light emitting element layer E.

The buffer layer BL may be formed between the substrate 110 and the gate insulating layer 111a to protect the thin film transistor 112. The buffer layer BL may be disposed on the entire surface (or front surface) of the substrate 110. The pixel power line EVDD for pixel driving may be disposed between the buffer layer BL and the substrate 110. The pixel power line EVDD may be disposed below the bank 115 while being spaced apart from the thin film transistor 112. The reference line RL may also be disposed between the buffer layer BL and the substrate 110. The reference line RL may be disposed in the non-light emission area NEA that does not overlap with the light emission area EA. The buffer layer BL may serve to block diffusion of a material contained in the substrate 110 into a transistor layer during a high temperature process of a manufacturing process of the thin film transistor. Optionally, the buffer layer BL may be omitted in some cases.

The thin film transistor 112 (or a drive transistor) according to an example may include an active layer 112a, a gate electrode 112b, a source electrode 112c, and a drain electrode 112d.

The active layer 112a may include a channel area, a drain area and a source area, which are formed in a thin film transistor area of a circuit area of the subpixel SP. The drain area and the source area may be spaced apart from each other with the channel area interposed therebetween.

The active layer 112a may be formed of a semiconductor material based on any one of amorphous silicon, polycrystalline silicon, oxide and organic material.

The gate insulating layer 111a may be formed on the channel area of the active layer 112a. As an example, the gate insulating layer 111a may be formed in an island shape only on the channel area of the active layer 112a, or may be formed on an entire front surface of the substrate 110 or the buffer layer BL, which includes the active layer 112a.

The gate electrode 112b may be formed on the gate insulating layer 111a to overlap the channel area of the active layer 112a.

The interlayer insulating layer 111b may be formed on the gate electrode 112b and the drain area and the source area of the active layer 112a. As in FIG. 4, the interlayer insulating layer 111b may be formed in the circuit area and an entire light emission area, in which light is emitted to the subpixel SP. However, embodiments of the present disclosure are not limited thereto, the interlayer insulating layer 111b may be patterned between the drain electrode 112d and the gate electrode 112b and drain region of the active layer 112a and may be arranged in an island shape, and moreover, may be patterned between the source electrode 112c and the gate electrode 112b and source region of the active layer 112a and may be arranged in an island shape.

The source electrode 112c may be electrically connected to the source area of the active layer 112a through a source contact hole provided in the interlayer insulating layer 111b overlapped with the source area of the active layer 112a. The drain electrode 112d may be electrically connected to the drain area of the active layer 112a through a drain contact hole provided in the interlayer insulating layer 111b overlapped with the drain area of the active layer 112a.

The drain electrode 112d and the source electrode 112c may be made of the same metal material. For example, each of the drain electrode 112d and the source electrode 112c may be made of a single metal layer, a single layer of an alloy or a multi-layer of two or more layers, which is the same as or different from that of the gate electrode.

In addition, the circuit area may further include first and second switching thin film transistors disposed together with the thin film transistor 112, and a capacitor. Since each of the first and second switching thin film transistors is provided on the circuit area of the subpixel SP to have the same structure as that of the thin film transistor 112, its description will be omitted. The capacitor (not shown) may be provided in an overlap area between the gate electrode 112b and the source electrode 112c of the thin film transistor 112, which overlap each other with the interlayer insulating layer 111b interposed therebetween.

Additionally, in order to prevent a threshold voltage of the thin film transistor provided in a pixel area from being shifted by light, the display panel or the substrate 110 may further include a light shielding layer (not shown) provided below the active layer 112a of at least one of the thin film transistor 112, the first switching thin film transistor or the second switching thin film transistor. The light shielding layer may be disposed between the substrate 110 and the active layer 112a to shield light incident on the active layer 112a through the substrate 110, thereby minimizing a change in the threshold voltage of the transistor due to external light. Also, since the light shielding layer is provided between the substrate 110 and the active layer 112a, the thin film transistor may be prevented from being seen by a user.

The passivation layer 111c may be provided on the substrate 110 to cover the pixel area. The passivation layer 111c covers a drain electrode 112d, a source electrode 112c and a gate electrode 112b of the thin film transistor 112, and the buffer layer BL.

Meanwhile, the display apparatus 100 according to one embodiment of the present disclosure may be provided such that the bank 115 is arranged on one side of the light emission area EA where the circuit area CA is arranged, and on the other side of the light emission area EA. For example, one side of the light emission area EA may mean a left area adjacent to a left side of the light emission area EA of FIG. 4. And, the other side of the light emission area EA may mean a right area adjacent to a right side of the light emission area EA of FIG. 4. Accordingly, as illustrated in FIG. 4, a pixel power line EVDD can overlap with the bank 115 in the third direction (Z-axis direction), and a reference line RL can overlap with the bank 115 in the third direction (Z-axis direction). The passivation layer 111c may be formed over the entire circuit area and light-emitting area. This passivation layer 111c may be omitted. The overcoat layer 113 may be disposed on the passivation layer 111c.

The overcoat layer 113 may be provided on the substrate 110 to cover the passivation layer 111c. When the passivation layer 111c is omitted, the overcoat layer 113 may be provided on the substrate 110 to cover the circuit area. The overcoat layer 113 may be formed in the circuit area CA in which the thin film transistor 112 is disposed and the light emission area EA. In addition, the overcoat layer 113 may be formed in the other non-display area NDA except a pad area PA of the non-display area NDA and the entire display area DA. For example, the overcoat layer 113 may include an extension portion (or an enlarged portion) extended or enlarged from the display area DA to the other non-display area NDA except the pad area PA. Therefore, the overcoat layer 113 may have a size relatively wider than that of the display area DA.

The overcoat layer 113 according to one example may be formed to have a relatively thick thickness, thereby providing a flat surface on the display area DA and the non-display area NDA. For example, the overcoat layer 113 may be made of an organic material such as photo acryl, benzocyclobutene, polyimide and fluorine resin.

Referring again to FIG. 4, an upper color filter UCF may be placed on the overcoat layer 113. Since an upper surface 113a of the overcoat layer 113 is provided flat, the upper color filter UCF on the overcoat layer 113 can also be provided flat, and the pixel electrode 114 formed thereon can also be provided in a flat shape. Additionally, the organic light-emitting layer 116 and the reflective electrode 117 formed on the pixel electrode 114 can also be provided in a flat shape. Since the pixel electrode 114, the organic light emitting layer 116, the reflective electrode 117, that is, the light emitting element layer E is provided to be flat in the light emission area EA, a thickness of each of the pixel electrode 114, the organic light emitting layer 116 and the reflective electrode 117 in the light emission area EA may be uniformly formed. Therefore, the organic light emitting layer 116 may be uniformly emitted without deviation in the light emission area EA.

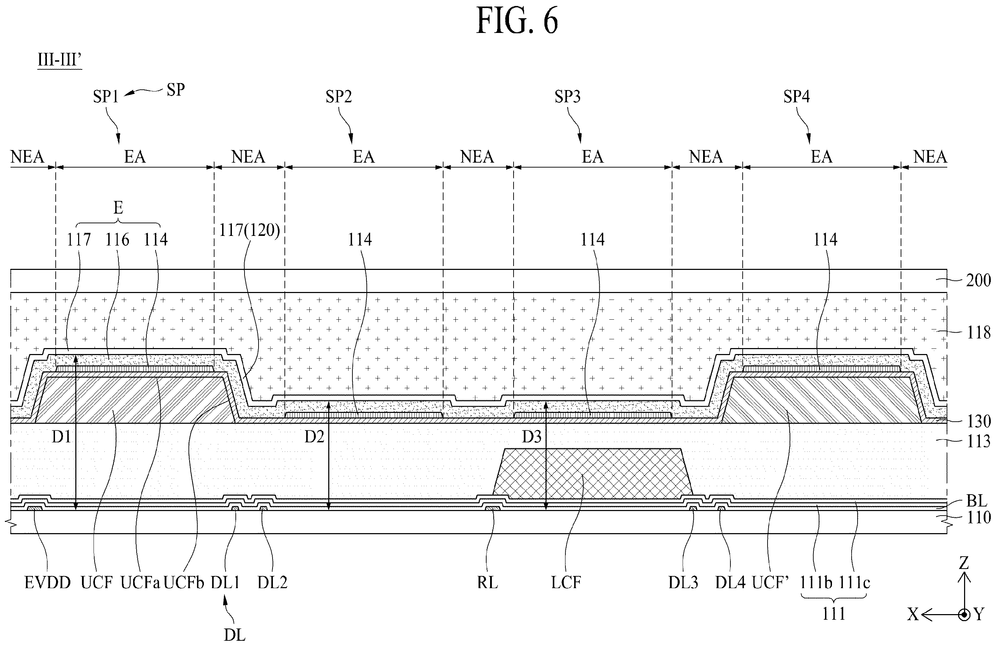

The upper color filter UCF may be provided between the overcoat layer 113 and the pixel electrode 114. The upper color filter UCF may be a red color filter (or a first color filter) that converts white light emitted by the organic light-emitting layer 116 into red light. The second subpixel SP2, which is a white subpixel, may not include a color filter because the organic light-emitting layer 116 emits white light. The upper color filter UCF' (shown in FIG. 6) included in the fourth subpixel SP4 may be a green color filter (or a second color filter) that converts white light emitted by the organic light-emitting layer 116 into green light.

Meanwhile, the display apparatus 100 according to one embodiment of the present disclosure may further include a blue color filter (or a third color filter) that converts white light into blue light. For example, the blue color filter may be placed in the third subpixel SP3. According to one example, the blue color filter may be placed under the overcoat layer 113 (shown in FIG. 6). Accordingly, the blue color filter may be referred to as a lower color filter LCF.

Again, referring to FIG. 3, the upper color filter UCF according to one example may include a flat surface UCFa and an inclined surface UCFb. The flat surface UCFa may be a surface that partially contacts the pixel electrode 114 (or a lower surface of the pixel electrode 114). The inclined surface UCFb is connected to the flat surface UCFa and may be an inclined surface. For example, the inclined surface UCFb may be arranged to form an obtuse angle (θ) with the flat surface UCFa. According to one embodiment of the present disclosure, the display apparatus 100 may be arranged so that the inclined surface UCFb of the upper color filter UCF forms the obtuse angle with the flat surface UCFa, so that the reflective electrode 117 arranged on the inclined surface UCFb of the upper color filter UCF may also be arranged so as to be inclined, and the inclined reflective electrode 117 (or reflective portion 120) may be provided so as to reflect light directed to the adjacent subpixel toward the emitting subpixel.

Referring to FIG. 4, the pixel electrode 114 of one subpixel SP, for example, the first subpixel SP1, among the plurality of subpixels may be formed on the upper color filter UCF. The pixel electrode 114 can be connected to the drain electrode or source electrode of the thin film transistor 112 through a contact hole penetrating the overcoat layer 113 and the passivation layer 111c. Each of one edge portion of the pixel electrode 114 and the other edge portion of the pixel electrode 114 may be covered by the bank 115. The pixel electrode 114 may be made of at least one of a transparent metal material and a semi-transparent metal material.

Because the display apparatus 100 according to an embodiment of the present disclosure is configured as the bottom emission type, the pixel electrode 114 may be formed of a transparent conductive material (or TCO), such as indium tin oxide (ITO) or indium zinc oxide (IZO) capable of transmitting light, or a semi-transmissive conductive material such as magnesium (Mg), silver (Ag), or an alloy of Mg and Ag.

Meanwhile, the material constituting the pixel electrode 114 may include MoTi. The pixel electrode 114 may be a first electrode or an anode electrode.

The bank 115 is an area where light is not emitted, and may be provided on one side and the other side of the light-emission area EA of each of the plurality of subpixels SP. For example, the bank 115 may be placed in a non-light-emission area NEA where the circuit area CA is placed. As shown in FIG. 4, the bank 115 may be formed so as to cover a portion of one edge of the pixel electrode 114 of each of the subpixels SP that is connected to the thin film transistor 112. In addition, the bank 115 may be formed so as to cover the other edge of the pixel electrode 114 of each of the subpixels SP. That is, the bank 115 can partially cover the pixel electrode 114. Accordingly, the bank 115 can prevent the pixel electrode 114 and the reflective electrode 117 from coming into contact in the circuit area CA, and can prevent the pixel electrode 114 and the reflective electrode 117 from coming into contact in the non-light emission area NEA adjacent to the other side of the light emission area EA. An exposed portion of the pixel electrode 114 that is not covered by the bank 115 may be included in the light-emission portion (or light-emission area EA).

After the bank 115 is formed, an organic light emitting layer 116 may be formed to cover the pixel electrodes 114 and the bank 115. Thus, the bank 115 may be provided between the pixel electrodes 114 and the organic light emitting layer 116. The bank 115 may be expressed in terms of a pixel-defining membrane. The bank 115 according to one example may comprise organic material and/or inorganic material.

The organic light-emitting layer 116 can be formed between the pixel electrode 114 and the reflective electrode 117. According to one example, the organic light emitting layer 116 may be disposed in the light emission area EA and the non-light emission area NEA. The organic light emitting layer 116 may be provided between the pixel electrode 114 and the reflective electrode 117. Thus, when a voltage is applied to each of the pixel electrode 114 and the reflective electrode 117, an electric field is formed between the pixel electrode 114 and the reflective electrode 117. Therefore, the organic light emitting layer 116 may emit light. The organic light emitting layer 116 may be formed of a plurality of subpixels SP and a common layer provided on the bank 115.

The organic light emitting layer 116 according to an embodiment may be provided to emit white light. The organic light emitting layer 116 may include a plurality of stacks which emit lights of different colors. For example, the organic light emitting layer 116 may include a first stack, a second stack, and a charge generating layer (CGL) provided between the first stack and the second stack. The light emitting layer may be provided to emit the white light, and thus, each of the plurality of subpixels SP may include a color filter CF suitable for a corresponding color.

The first stack may be provided on the pixel electrode 114 and may be implemented a structure where a hole injection layer (HIL), a hole transport layer (HTL), an emission layer (EML(B)), and an electron transport layer (ETL) are sequentially stacked.

The charge generating layer may supply an electric charge to the first stack and the second stack. The charge generating layer may include an N-type charge generating layer for supplying an electron to the first stack and a P-type charge generating layer for supplying a hole to the second stack. The N-type charge generating layer may include a metal material as a dopant.

The second stack may be provided on the first stack and may be implemented in a structure where a hole transport layer (HTL), a yellow-green (YG) emission layer (EML(YG)), and an electron injection layer (EIL) are sequentially stacked.

In the display apparatus 100 according to an embodiment of the present disclosure, because the organic light emitting layer 116 is provided as a common layer, the first stack, the charge generating layer, and the second stack may be arranged all over the plurality of subpixels SP. The organic light emitting layer 116, according to another example, may be provided in a three-stacked structure or a four-stacked structure, depending on the number of stacks stacked.

The reflective electrode 117 may be formed on the organic light emitting layer 116. The reflective electrodes 117 may be disposed in the light emission area EA and the non-light emission area NEA. The reflective electrode 117 according to one example may include a metal material. The reflective electrode 117 may reflect the light emitted from the organic light emitting layer 116 in the plurality of subpixels SP toward the lower surface of the substrate 110. Therefore, the display apparatus 100 according to one embodiment of the present disclosure may be implemented as a bottom emission type display apparatus.

The display apparatus 100 according to one embodiment of the present disclosure is a bottom emission type and has to reflect light emitted from the light emitting layer 116 toward the substrate 110, and thus the reflective electrode 117 may be made of a metal material having high reflectance. The reflective electrode 117 according to one example may be formed of a metal material having high reflectance such as a stacked structure (Ti/Al/Ti) of aluminum and titanium, a stacked structure (ITO/Al/ITO) of aluminum and ITO, an Ag alloy and a stacked structure (ITO/Ag alloy/ITO) of Ag alloy and ITO. The Ag alloy may be an alloy such as silver (Ag), palladium (Pd) and copper (Cu). The reflective electrode 117 may be expressed as terms such as a second electrode, a cathode electrode and a counter electrode.

On the other hand, in the display apparatus 100 according to one embodiment of the present disclosure, the reflective portion 120 may be a part of the reflective electrode 117. Thus, the reflective portion 120 may reflect light, which is directed toward the adjacent sub-pixel SP, toward the light emission area EA and/or the non-light emission area NEA of the emitting sub-pixel SP. The reflective portion 120 may mean a reflective electrode 117 that is arranged obliquely in a non-light emission area NEA.

The encapsulation layer 118 is formed on the reflective electrode 117. The encapsulation layer 118 serves to prevent oxygen or moisture from being permeated into the organic light emitting layer 116 and the reflective electrode 117. To this end, the encapsulation layer 118 may include at least one inorganic film and at least one organic film.

Meanwhile, as shown in FIG. 3, the encapsulation layer 118 may be disposed not only in the light emission area EA but also in the non-light emission area NEA. The encapsulation layer 118 may be disposed between the reflective electrode 117 and an opposing substrate 200.

Referring to FIG. 3, in the display apparatus 100 according to one embodiment of the present disclosure, an organic light-emitting layer 116 may be provided to cover the upper color filter UCF. Since the organic light-emitting layer 116 is provided as a common layer in a plurality of subpixels SP, it can cover the upper color filter UCF protruding from the overcoat layer 113 toward the opposing substrate 200. The display apparatus 100 according to one embodiment of the present disclosure may have a structural feature in which the organic light-emitting layer 116 is partially in contact with the upper color filter UCF by being provided with a bank-less structure. For example, as shown in FIG. 3, the organic light-emitting layer 116 in the first subpixel SP1 may be in contact with a part of the flat surface UCFa of the upper color filter UCF and the inclined surface UCFb of the upper color filter UCF. The part of the flat surface UCFa that the organic light-emitting layer 116 comes into contact with may refer to the part of the flat surface UCFa of the upper color filter UCF that is not in contact with the pixel electrode 114.

As a result, the display apparatus 100 according to one embodiment of the present disclosure is provided such that the reflective electrode 117 in the non-light emission area NEA is partially positioned closer to the substrate 110 than the pixel electrode 114, so that light directed toward an adjacent subpixel can be emitted outside the substrate 110 in the form of the direct reflected light EL1 and/or the indirect reflected light EL2 towards the emitting subpixel (e.g., the first subpixel SP1), thereby improving light extraction efficiency.

In addition, the display apparatus 100 according to the present disclosure is provided such that the overcoat layer 113 and the color filter (or upper color filter UCF) included in one (for example, the first subpixel SP1) of the plurality of subpixels have different refractive indices, so that the light extraction efficiency can be maximized through total reflection at the interface between the overcoat layer 113 and the color filter (or upper color filter UCF).

Additionally, since the display apparatus 100 according to the present disclosure can extract light in the light-emission area EA and/or the non-light emission area NEA through the difference in refractive indices between the overcoat layer 113 and the color filter (or the upper color filter UCF) and the reflective electrode 117 positioned closer to the substrate 110 than the pixel electrode 114, the display apparatus can have the same light-emitting efficiency or improve the light-emitting efficiency more than that with low power compared to a display apparatus that does not have the difference in refractive indices between the overcoat layer and the color filter (or the upper color filter) or does not have the reflective electrode positioned closer to the substrate than the pixel electrode, so that the overall power consumption can be reduced.

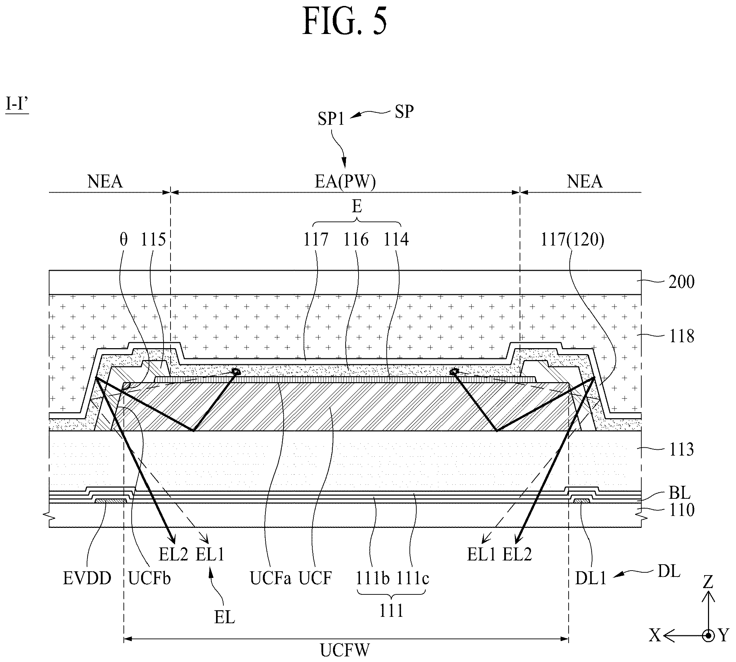

FIG. 5 is a schematic cross-sectional view of a display apparatus according to the second embodiment of the present disclosure.

Referring to FIG. 5, the display apparatus 100 according to the second embodiment of the present disclosure is the same as the display apparatus according to FIG. 1 described above, except that the structure of the bank 115 is changed. Therefore, the same drawing symbols are assigned to the same configurations, and only different configurations are described below.

In the case of the display apparatus according to FIG. 1, the bank 115 may not be placed between the plurality of sub-pixels SP adjacently placed in the first direction (X-axis direction). Accordingly, in the case of the display apparatus according to FIG. 1, some of the light emitted from the organic light-emitting layer 116 may pass through the pixel electrode 114, the upper color filter UCF, and the organic light-emitting layer 116 and then be reflected by the reflective portion 120 and emitted as the direct reflected light EL1, so that the light extraction efficiency may be improved. In addition, in the case of the display apparatus according to FIG. 1, some of the light emitted from the organic light-emitting layer 116 passes through the pixel electrode 114, is totally reflected at the interface between the upper color filter UCF and the overcoat layer 113, passes through the organic light-emitting layer 116, and is then reflected by the reflective portion 120 to be emitted as the indirectly reflected light EL2, so that the light extraction efficiency can be further improved.

In contrast, in the case of the display apparatus according to FIG. 5, the bank 115 may also be arranged between the plurality of subpixels SP adjacently arranged in the first direction (X-axis direction). Accordingly, in the case of the display apparatus according to FIG. 5, one subpixel (or the first subpixel SP1) may further include the bank 115 covering the edge of the pixel electrode 114 and the inclined surface UCFb of the upper color filter UCF. Accordingly, in the case of the display apparatus according to FIG. 5, some of the light emitted from the organic light-emitting layer 116 may pass through the pixel electrode 114, the upper color filter UCF, the bank 115, and the organic light-emitting layer 116 and then be reflected by the reflective portion 120 and emitted as the direct reflected light EL1, so that the light extraction efficiency may be improved. In addition, in the case of the display apparatus according to FIG. 5, some of the light emitted from the organic light-emitting layer 116 passes through the pixel electrode 114, is totally reflected at the interface between the upper color filter UCF and the overcoat layer 113, and passes through the bank 115 and the organic light-emitting layer 116 and is reflected by the reflective portion 120 to be emitted as the indirectly reflected light EL2, so that the light extraction efficiency can be further improved. As a result, in the case of the display apparatus according to Fig. 5, since the configuration of the bank 115 is added, an optical path through which light emitted from the organic light-emitting layer 116 passes through the bank 115 can be added.

Meanwhile, the display apparatus 100 according to FIG. 5 is additionally provided with a bank 115 covering both edges of the pixel electrode 114, so that a reflection length (or reflection area) of the reflective portion 120 arranged obliquely in the non-light emission area NEA can be provided longer than a reflection length (or reflection area) of the reflective portion 120 provided in the display apparatus according to FIG. 1. Therefore, the display apparatus 100 according to the second embodiment of the present disclosure can maximize the improvement in light extraction efficiency by increasing the reflection length (or reflection area) of the reflection portion 120 that is arranged obliquely in the non-light emission area NEA.

FIG. 6 is a schematic cross-sectional view taken along line III-III' of FIG. 2, showing a display apparatus according to the third embodiment of the present disclosure.

Referring to FIG. 6, the display apparatus 100 according to a third embodiment of the present disclosure is the same as the display apparatus according to FIG. 1 described above, except that the configuration of a low-temperature inorganic film 130 is added, and the plurality of subpixels SP further include a second subpixel SP2 (or another subpixel SP2) having a different structure from the first subpixel SP1 (or one subpixel SP1), a third subpixel SP3 (or another one subpixel SP3), and a fourth subpixel SP4 having a similar structure to the first subpixel SP1. Therefore, the same drawing symbols are assigned to the same configurations, and only different configurations are described below.

Meanwhile, in the display apparatus 100 according to the third embodiment of the present disclosure, the fourth subpixel SP4 may have the same structure as the first subpixel SP1 described above, except that it includes an upper color filter UCF' having a different color (e.g., green color) than the upper color filter UCF of the first subpixel SP1. Therefore, the description of the fourth subpixel SP4 is replaced with the description of the first subpixel SP1 described above.

In the case of the display apparatus according to FIG. 1, since the pixel electrode 114 is formed directly on the upper surface UCFa of the upper color filter UCF, the pixel electrode 114 may have a structural feature in which it is in direct contact with the upper color filter UCF. In addition, in the case of the display apparatus according to FIG. 1, one subpixel SP1 (e.g., the first subpixel SP1) including a plurality of subpixels may be provided with a structure in which the overcoat layer 113, the upper color filter UCF, the pixel electrode 114, the organic light-emitting layer 116, and the reflective electrode 117 are sequentially laminated in a direction from the substrate 110 toward the opposing substrate 200. Accordingly, in the case of the display apparatus according to FIG. 1, the reflective portion 120 may be provided on the inclined surface UCFb of the upper color filter UCF that protrudes upward (or in the direction in which the opposing substrate 200 is provided) from the upper surface of the overcoat layer 113, and as a result, light directed toward the adjacent subpixel SP may be reflected by the reflective portion 120 and emitted toward the emitting subpixel, thereby improving light extraction efficiency.

In contrast, in the case of the display apparatus according to FIG. 6, one subpixel SP1 (e.g., the first subpixel SP1) may further include a low-temperature inorganic film 130 disposed between the pixel electrode 114 and the upper color filter UCF. According to one example, the low-temperature inorganic film 130 is intended to improve a roughness of the upper surface UCFa of the upper color filter UCF. In addition, the low-temperature inorganic film 130 is intended to increase an adhesion between the upper color filter UCF and the pixel electrode 114.

The upper color filter UCF may be formed of an organic material, and thus the upper surface UCFa of the upper color filter UCF formed of the organic material may have roughness. Since the upper surface UCFa of the upper color filter UCF has roughness, the adhesion between the pixel electrode 114 and the upper color filter UCF may be weak. Accordingly, the display apparatus 100 according to FIG. 6 can improve roughness and flatten the upper surface UCFa of the upper color filter UCF by having the low-temperature inorganic film 130 placed between the pixel electrode 114 and the upper color filter UCF, so that the low-temperature inorganic film 130 covers the upper surface UCFa of the upper color filter UCF. Accordingly, in the display apparatus 100 according to FIG. 6, since the pixel electrode 114 is arranged on the upper surface of the flat low-temperature inorganic film 130, the adhesion between the pixel electrode 114 and the low-temperature inorganic film 130 can be improved, and as a result, the adhesion between the upper color filter UCF and the pixel electrode 114 can be increased. Accordingly, the display apparatus 100 according to FIG. 6 can have a reduced defect rate due to increased adhesion between the upper color filter UCF and the pixel electrode 114, thereby improving the yield.

In the display apparatus 100 according to FIG. 6, the low-temperature inorganic film 130 may be formed of SiO₂, but is not limited thereto, and may be formed of another inorganic film such as SiNx if it can increase the adhesion between the upper color filter UCF and the pixel electrode 114.

According to one example, a low-temperature inorganic film 130 may be provided with a thickness of 2000 Å to 6000 Å. When the thickness of the low-temperature inorganic film is less than 2000 Å, a degree of planarization of the upper color filter UCF may be minimal, and thus the improvement in adhesion between the upper color filter UCF and the pixel electrode 114 may be minimal. Additionally, when the thickness of the low-temperature inorganic film 130 exceeds 6000 Å, a tact time for forming the low-temperature inorganic film increases, which may result in a low yield. Accordingly, the display apparatus 100 according to the third embodiment of the present disclosure can reduce the tact time while improving the adhesion between the upper color filter UCF and the pixel electrode 114 by having the low-temperature inorganic film 130 having a thickness of 2000 Å to 6000 Å.

Meanwhile, the low-temperature inorganic film 130 may be formed to cover the upper color filter UCF (or the upper color filter UCF') after the upper color filter UCF (or the upper color filter UCF' of the fourth sub-pixel SP4) of the first sub-pixel SP1 is formed. If an inorganic film is formed on the upper color filter at a high temperature (e.g., a high temperature exceeding 230 degrees Celsius (°C)), the upper color filter may be damaged by the high temperature. Accordingly, the display apparatus 100 according to the third embodiment of the present disclosure can be formed so that the inorganic film covers the upper color filter UCF (or the upper color filter UCF') at a low temperature of 230 degrees Celsius or less. Accordingly, the inorganic film disposed between the pixel electrode 114 and the upper color filter UCF (or upper color filter UCF') can be expressed in terms of a low-temperature inorganic film. That is, the term "low-temperature inorganic film" used in the present disclosure may refer to an inorganic film formed at a low temperature of 230 degrees Celsius or less.

Referring again to FIG. 6, in the display apparatus 100 according to the third embodiment of the present disclosure, the low-temperature inorganic film 130 may be provided as a common layer in the first to fourth sub-pixels SP1, SP2, SP3, SP4. Accordingly, as shown in FIG. 6, in the first subpixel SP1, the low-temperature inorganic film 130 may be provided to cover the flat surface UCFa and the inclined surface UCFb of the upper color filter UCF. And, in the fourth sub-pixel SP4 having a structure similar to that of the first sub-pixel SP1, the low-temperature inorganic film 130 may be provided to cover the flat surface and the inclined surface of the upper color filter UCF'. However, since the second subpixel SP2 (or another subpixel SP2) positioned adjacent to the first subpixel SP1 has a different stacking structure from the first subpixel SP1, the arrangement structure of the low-temperature inorganic film 130 may be different from that of the first subpixel.

For example, as shown in FIG. 6, the second subpixel SP2 (or another subpixel SP2) may be provided with a structure including the overcoat layer 113 disposed on the substrate 110 and a pixel electrode 114 disposed on the overcoat layer 113. Here, the low-temperature inorganic film 130 that is arranged to extend from the first subpixel SP1 to the second subpixel SP2 can be arranged between the overcoat layer 113 and the pixel electrode 114 in the second subpixel SP2. That is, since the second subpixel SP2 is a white subpixel and therefore does not include a color filter, the low-temperature inorganic film 130 can be arranged between the overcoat layer 113 and the pixel electrode 114.

The third subpixel SP3 (or another one subpixel SP3) is arranged adjacent to the second subpixel SP2 and may be provided with a structure including a lower color filter LCF arranged on the substrate 110, the overcoat layer 113 arranged on the lower color filter LCF, and the pixel electrode 114 arranged on the overcoat layer 113. Accordingly, the low-temperature inorganic film 130 extending from the second subpixel SP2 to the third subpixel SP3 can be arranged between the overcoat layer 113 and the pixel electrode 114 in the third subpixel SP3. Here, the lower color filter LCF may be a blue color filter. Since the blue color filter has a relatively lower refractive index than the red color filter or the green color filter, a refractive index difference between the overcoat layer 113 and the blue color filter may not be large. Accordingly, the blue color filter can be placed under the overcoat layer 113, and some of the light emitted from the organic light-emitting layer 116 of the third subpixel SP3 can pass through the lower color filter LCF without being totally reflected at the interface between the overcoat layer 113 and the lower color filter LCF and be emitted to an outside of the substrate 110.

The fourth sub-pixel SP4 is positioned adjacent to the third sub-pixel SP3 (or another one sub-pixel SP3) and may include an upper color filter UCF', which is a green color filter. The fourth sub-pixel SP4 is the same as the first sub-pixel SP1 except for the color of the color filter, and therefore a detailed description thereof is omitted.

As a result, in the display apparatus 100 according to the third embodiment of the present disclosure, since the low-temperature inorganic film 130 is disposed between the upper color filter and the pixel electrode 114 in each of the first subpixel SP1 and the fourth subpixel SP4, the adhesive strength between the upper color filter and the pixel electrode 114 can be improved through the low-temperature inorganic film 130, so that the defect rate can be reduced. In addition, since the display apparatus 100 according to the third embodiment of the present disclosure has a low-temperature inorganic film 130 formed continuously without a break in the first to fourth sub-pixels SP1, SP2, SP3, SP4, moisture and oxygen that may permeate from the opposing substrate 200 toward the thin film transistor 112 can be doubly blocked together with the encapsulation layer 118, so that the reliability of the thin film transistor 112 can be improved.

Meanwhile, as shown in FIG. 6, in the display apparatus 100 according to the third embodiment of the present disclosure, the reflective electrode 117 can be arranged sequentially in the plurality of subpixels SP. Accordingly, the reflective electrode 117 disposed in the first subpixel SP1 (or the light-emission area EA of one subpixel SP1) including the upper color filter UCF protruding from the overcoat layer 113 toward the opposing substrate 200 may be disposed further away from the substrate 110 than the reflective electrode 117 disposed in the second subpixel SP2 (or the light-emission area EA of the other subpixel SP2). For example, the reflective electrode 117 arranged in the light-emission area EA of the first subpixel SP1 may be arranged at a first distance D1 away from an upper surface of the substrate 110, and the reflective electrode 117 arranged in the light-emission area EA of the second subpixel SP2 may be arranged at a second distance D2 shorter than the first distance D1 away from the upper surface of the substrate 110.

Since the third sub-pixel SP3 (or another one sub-pixel SP3) has the overcoat layer 113 for planarization disposed on the lower color filter LCF, the reflective electrode 117 disposed on the second sub-pixel SP2 (or the light-emission area EA of the other sub-pixel SP2) and the reflective electrode 117 disposed on the third sub-pixel SP3 (or the light-emission area EA of the another one sub-pixel SP3) can be disposed at substantially the same distances from the substrate 110. For example, the reflective electrode 117 arranged in the light-emission area EA of the second subpixel SP2 may be arranged to be spaced apart from the upper surface of the substrate 110 by the second distance D2, and the reflective electrode 117 arranged in the light-emission area EA of the third subpixel SP3 may be arranged to be spaced apart from the upper surface of the substrate 110 by a third distance D3 that is substantially the same as the second distance D2. Here, the term "substantially the same" means that two values are the same as or similar to each other, and the difference therebetween may be within a predetermined tolerance margin or a measurement error range. For example, the tolerance margin or the measurement error range may be ±20%, ±10%, ±5%, or ±1%. Accordingly, the display apparatus 100 according to the third embodiment of the present disclosure may have a structural feature in which the light-emitting element layers of each of the second subpixel SP2 and the third subpixel SP3 are arranged closer to the substrate 110 than the light-emitting element layers of each of the first subpixel SP1 and the fourth subpixel SP4.

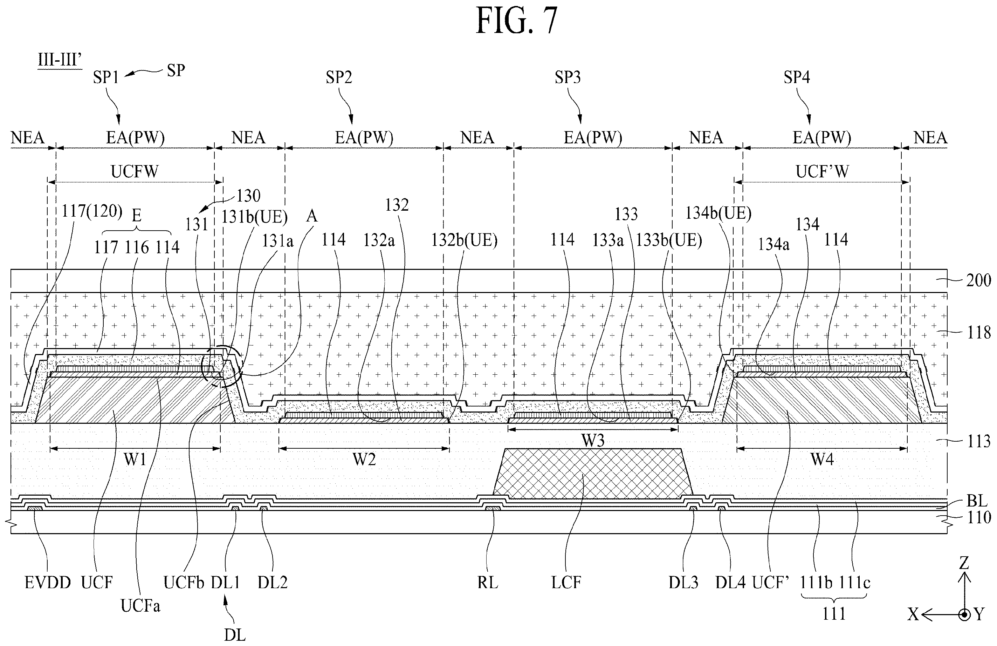

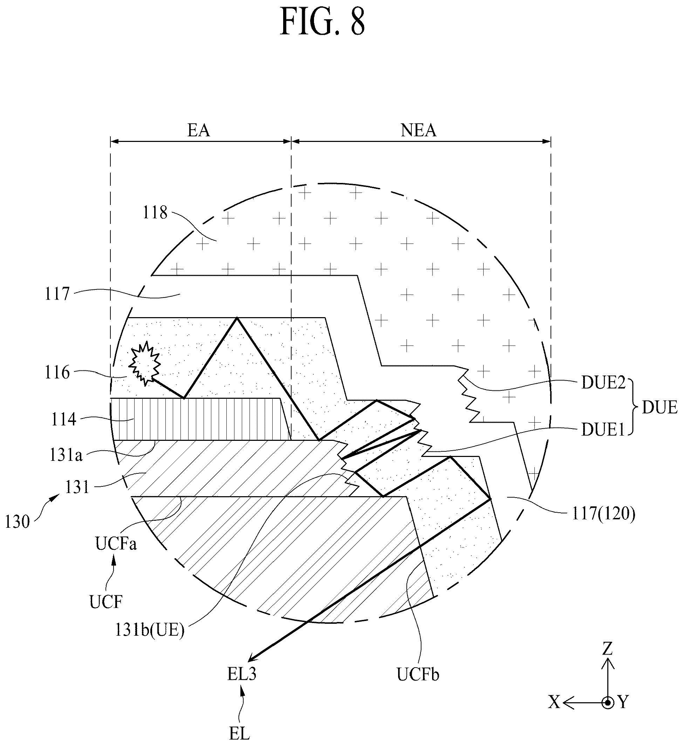

FIG. 7 is a schematic cross-sectional view of a display apparatus according to the fourth embodiment of the present disclosure, and FIG. 8 is an enlarged view of part A of FIG. 7.

Referring to FIG. 7, the display apparatus 100 according to the fourth embodiment of the present disclosure is the same as the display apparatus according to FIG. 6 described above, except that a structure of the low-temperature inorganic film 130 is changed. Therefore, the same drawing reference numerals are given to the same configurations, and only different configurations will be described below.

In the case of the display apparatus according to FIG. 6, since the low-temperature inorganic film 130 is formed as a common layer on the first to fourth subpixels SP1, SP2, SP3, SP4, the prevention of moisture and oxygen penetration is improved, and the reliability of the thin film transistor 112 can be improved. In addition, in the case of the display apparatus according to FIG. 6, since the low-temperature inorganic film 130 is disposed between the pixel electrode 114 and the upper color filter UCF (or UCF') in each of the first subpixel SP1 and the fourth subpixel SP4, the adhesion between the upper color filter UCF and the pixel electrode 114 through the low-temperature inorganic film 130 can be increased, and thus the yield can be improved due to a decrease in the defect rate.

In contrast, in the case of the display apparatus according to FIG. 7, the low-temperature inorganic film 130 can be divided and placed in each of the first to fourth sub-pixels SP1, SP2, SP3, SP4. For example, in the case of the display apparatus according to FIG. 7, the low-temperature inorganic film 130 may include a first low-temperature inorganic film 131 disposed in the first subpixel SP1, a second low-temperature inorganic film 132 disposed in the second subpixel SP2, a third low-temperature inorganic film 133 disposed in the third subpixel SP3, and a fourth low-temperature inorganic film 134 disposed in the fourth subpixel SP4.

The low-temperature inorganic film 130 of the display apparatus according to Fig. 7 can be formed on each of the plurality of subpixels SP1, SP2, SP3, SP4 through the following process. First, the low-temperature inorganic film 130 can be deposited as a common layer on the first to fourth subpixels SP1, SP2, SP3, SP4. Second, after the pixel electrode 114 is deposited as a common layer on the first to fourth subpixels SP1, SP2, SP3, and SP4, it can be patterned on each of the plurality of subpixels through a photoresist process and an etching process. Accordingly, the pixel electrode 114 can be placed only on each of the first to fourth subpixels SP1, SP2, SP3, and SP4. Third, a first wet etch process may be performed to partially etch the low-temperature inorganic film 130 so that the low-temperature inorganic film 130 is disposed on each of the first to fourth subpixels SP1, SP2, SP3, and SP4. In this case, since the pixel electrode 114 is in contact with the upper surface of the low-temperature inorganic film 130, only a side surface of the low-temperature inorganic film 130 may be etched through the wet etch process. Fourth, in order to prevent the pixel electrode 114 from protruding further than the low-temperature inorganic film 130 and forming an undercut under the pixel electrode 114, a second wet etch process for etching the pixel electrode 114 may be performed. This is because if the undercut is formed under the pixel electrode 114, the organic light-emitting layer 116 formed in a subsequent process may be disconnected, resulting in a defect.

Through the above process, the display apparatus 100 according to FIG. 7 may include a first low-temperature inorganic film 131 disposed in the first subpixel SP1, a second low-temperature inorganic film 132 disposed in the second subpixel SP2, a third low-temperature inorganic film 133 disposed in the third subpixel SP3, and a fourth low-temperature inorganic film 134 disposed in the fourth subpixel SP4, and each of the first to fourth low-temperature inorganic films 131, 132, 133, 134 may be provided discontinuously and disconnected from each other.

As shown in FIG. 7, the low-temperature inorganic film 130 (or the second low-temperature inorganic film 132) and the pixel electrode 114 of the second subpixel SP2 (or another subpixel SP2) may be disconnected from the low-temperature inorganic film 130 (or the first low-temperature inorganic film 131) and the pixel electrode 114 of the first subpixel SP1 (or one subpixel SP1). The low-temperature inorganic film 130 (or the third low-temperature inorganic film 133) and the pixel electrode 114 of the third subpixel SP3 (or another one subpixel SP3) may be disconnected from the low-temperature inorganic film 130 (or the second low-temperature inorganic film 132) and the pixel electrode 114 of the second subpixel SP2 (or another subpixel SP2). Additionally, the low-temperature inorganic film 130 (or the fourth low-temperature inorganic film 134) and the pixel electrode 114 of the fourth subpixel SP4 may be disconnected from the low-temperature inorganic film 130 (or the third low-temperature inorganic film 133) and the pixel electrode 114 of the third subpixel SP3 (or another one subpixel SP3).

Meanwhile, as described above, since the second wet etch process is performed to prevent the undercut from being formed under the pixel electrode 114, the display apparatus 100 according to FIG. 7 may have a structural feature in which a width W1 of the low-temperature inorganic film (or the first low-temperature inorganic film 131) in the first subpixel SP1 (or one subpixel SP1) is narrower than a width UCFW of the upper surface UCFa of the upper color filter UCF and wider than a width PW of the pixel electrode 114. In addition, a width W2 of the low-temperature inorganic film (or the second low-temperature inorganic film 132) in the second subpixel SP2 (or another subpixel SP2) may be provided to be wider than the width PW of the pixel electrode 114, and a width W3 of the low-temperature inorganic film (or the third low-temperature inorganic film 133) in the third subpixel SP3 (or another one subpixel SP3) may be provided to be wider than the width PW of the pixel electrode 114. In addition, a width W4 of the low-temperature inorganic film (or the fourth low-temperature inorganic film 134) in the fourth subpixel SP4 may be narrower than the width UCF'W of the upper surface of the upper color filter UCF' and wider than the width PW of the pixel electrode 114.

Referring again to FIG. 7, the low-temperature inorganic film 130 may include an upper surface and a side surface. The upper surface of the low-temperature inorganic film 130 may be in partial contact with a lower surface of the pixel electrode 114. The side surface of the low-temperature inorganic film 130 may be connected to the upper surface and may be provided at an angle. As described above, since the side surface of the low-temperature inorganic film 130 may be formed by the first wet etch process, the side surface of the low-temperature inorganic film 130 may include an unevenness UE. The unevenness UE may mean a structure having an irregular shape. For example, the unevenness UE may be a structure including a porous shape or a roughness shape.

Therefore, as shown in FIG. 7, the first low-temperature inorganic film 131 in the first subpixel SP1 (or one subpixel SP1) may include an upper surface 131a and a side surface 131b, and the side surface 131b of the first low-temperature inorganic film 131 may include irregularly shaped unevenness UE. The second low-temperature inorganic film 132 in the second subpixel SP2 (or another subpixel SP2) may include an upper surface 132a and a side surface 132b, and the side surface 132b of the second low-temperature inorganic film 132 may include irregularly shaped unevenness UE. The third low-temperature inorganic film 133 in the third subpixel SP3 (or another subpixel SP3) may include an upper surface 133a and a side surface 133b, and the side surface 133b of the third low-temperature inorganic film 133 may include irregularly shaped unevenness UE. The fourth low-temperature inorganic film 134 in the fourth subpixel SP4 may include an upper surface 134a and a side surface 134b, and the side surface 134b of the fourth low-temperature inorganic film 134 may include irregularly shaped unevenness UE.

As shown in FIG. 7, the display apparatus 100 according to the fourth embodiment of the present disclosure is provided with the low-temperature inorganic film 130 that is disconnected only for each subpixel SP1, SP2, SP3, SP4, so that the organic light-emitting layer 116 and the reflective electrode 117 can be arranged to extend to the side of the disconnected low-temperature inorganic film 130 and a side surface of the upper color filter UCF. Since the side surface of the disconnected low-temperature inorganic film 130 includes the unevenness UE, each of the organic light-emitting layer 116 and the reflective electrode 117 positioned on the side surface of the low-temperature inorganic film 130 may include a dummy unevenness DUE corresponding to the unevenness UE included in the side surface of the low-temperature inorganic film 130. For example, the organic light-emitting layer 116 may include a first dummy unevenness DUE1 having a shape corresponding to the unevenness UE on the side surface of the low-temperature inorganic film 130. The reflective electrode 117 (or reflective portion 120) may include a second dummy unevenness DUE2 having a shape corresponding to the first dummy unevenness DUE1. Since the first dummy unevenness DUE1 is formed at the interface between the organic light-emitting layer 116 and the reflective electrode 117 (or reflective portion 120), light incident on the first dummy unevenness DUE1 can be reflected by the reflective electrode 117 (or reflective portion 120) and emitted to the substrate 110.

For example, as shown in FIG. 8, light emitted from the organic light-emitting layer 116 and wave-guided (or totally reflected) between the pixel electrode 116 and the reflective electrode 117 may be irregularly reflected between the unevenness UE of the low-temperature inorganic film 130 and the first dummy unevenness DUE1 of the organic light-emitting layer 116, and then finally reflected by the reflective electrode 117 (or reflective portion 120) and emitted in the form of the indirectly reflected light EL3 toward the emitting subpixel. Accordingly, the display apparatus 100 according to the fourth embodiment of the present disclosure can emit light emitted from the organic light-emitting layer 116 and wave-guided to the substrate 110 through the unevenness UE of the low-temperature inorganic film 130, so that the light extraction efficiency can be improved. The indirectly reflected light EL3 emitted from the display apparatus 100 according to the fourth embodiment of the present disclosure is light that is wave-guided inside the substrate 110 and emitted to the outside of the substrate 110, and therefore can be expressed in terms of a waveguide-emitted light.

As a result, the display apparatus 100 according to the fourth embodiment of the present disclosure can further improve light extraction efficiency since the waveguide emitted light EL3 is added to the direct reflection light EL1 and a substrate mode emitted light EL2.

Meanwhile, in the display apparatus 100 according to the fourth embodiment of the present disclosure, the unevenness UE may be provided only on the side surface of the low-temperature inorganic film 130 provided on each of the first to fourth subpixels SP1, SP2, SP3, SP4, because the first wet etch process is performed while the pixel electrode 114 covers the low-temperature inorganic film 130. Accordingly, as shown in FIG. 8, the unevenness UE may not be formed on the upper surface (or upper surface 131a) of the low-temperature inorganic film 130 (or the first low-temperature inorganic film 131) that is not covered by the pixel electrode 114. If the unevenness is formed on the upper surface of the low-temperature inorganic film that is not covered by the pixel electrode, the haze and/or blur level may increase due to diffuse reflection by the unevenness, causing the image to appear blurry. Accordingly, the display apparatus 100 according to the fourth embodiment of the present disclosure has the unevenness UE only on the side surface of the low-temperature inorganic film 130 provided in each of the first to fourth sub-pixels SP1, SP2, SP3, SP4, thereby preventing an increase in haze and/or blur level, and thus preventing a deterioration in image quality.

Meanwhile, in the display apparatus 100 according to the fourth embodiment of the present disclosure, the second subpixel SP2 does not include a color filter, and the third subpixel SP3 has the lower color filter LCF disposed under the overcoat layer 113, so that the pixel electrode 114 may not directly contact the color filter. Accordingly, the second low-temperature inorganic film 132 arranged in the second subpixel SP2 and the third low-temperature inorganic film 133 arranged in the third subpixel SP3 can be omitted.

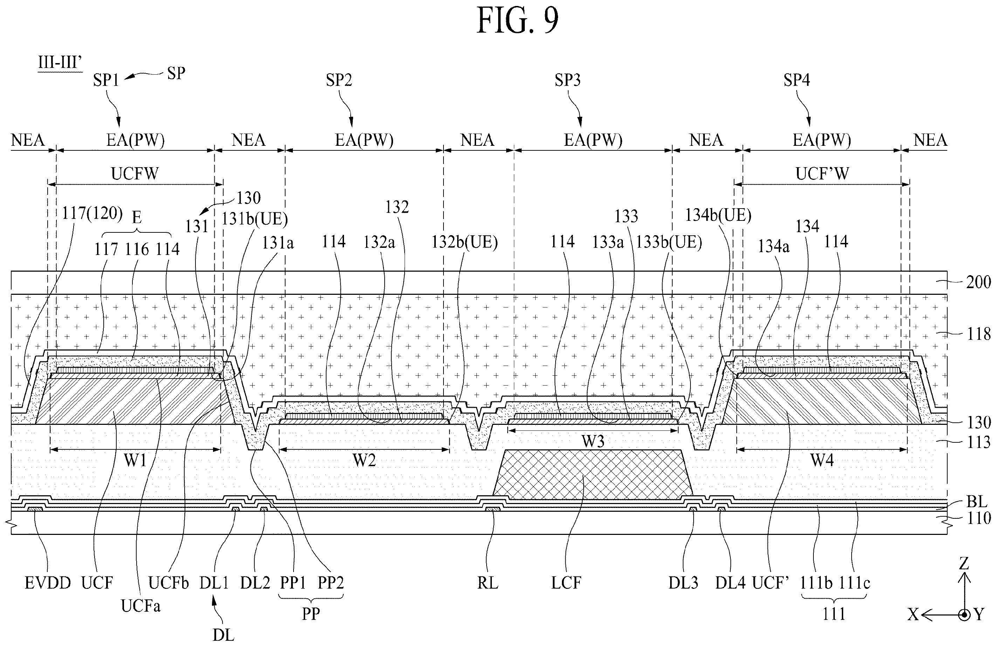

FIG. 9 is a schematic cross-sectional view of a display apparatus according to the fifth embodiment of the present disclosure.

Referring to FIG. 9, the display apparatus 100 according to the fifth embodiment of the present disclosure is the same as the display apparatus according to FIG. 7 described above, except that a configuration of a pattern portion PP is added. Therefore, the same drawing reference numerals are given to the same configurations, and only different configurations will be described below.

In the case of the display apparatus according to FIG. 7, the low-temperature inorganic film 130 may be divided and placed in each of the first to fourth sub-pixels SP1, SP2, SP3, SP4, and the side surface of the low-temperature inorganic film 130 in each sub-pixel SP may be provided to include the unevenness UE. Accordingly, in the case of the display apparatus according to FIG. 7, light emitted from the organic light-emitting layer 116 and wave-guided can be irregularly reflected between the unevenness UE of the low-temperature inorganic film 130 and the first dummy unevenness DUE1 of the organic light-emitting layer 116, and then finally reflected by the reflective electrode 117 (or reflective portion 120) and emitted toward the emitting subpixel, so that the light extraction efficiency can be improved.

In contrast, the display apparatus according to FIG. 9 may further include a pattern portion PP that is positioned on the substrate 110 and is concavely formed in the non-light emission area NEA between the plurality of subpixels. The pattern portion PP is intended to increase the reflection length (or reflection area) of the reflection portion 130. According to one example, the pattern portion PP may be formed by patterning at least a portion of the overcoat layer 113 disposed in the non-light emission area NEA. Since the overcoat layer 113 is intended to flatten the light-emission area EA and the non-light emission area NEA, it can be arranged to extend from the light-emission area EA to the non-light emission area NEA. The pattern portion PP can be formed concavely in the non-light emission area NEA between the plurality of subpixels SP by etching at least the portion of the overcoat layer 113 disposed in the non-light emission area NEA from the overcoat layer 113 that is flatly provided in the light emission area EA and the non-light emission area NEA.

In the display apparatus 100 according to FIG. 9, the reflective electrode 117 extends to the pattern portion PP and can be formed concavely along a shape of the pattern portion PP. Accordingly, the display apparatus 100 according to FIG. 9 may have a longer reflection length (or reflection area) for reflecting light compared to the reflective electrode 117 (or reflection portion 120) of the display apparatus 100 according to FIG. 7, since the reflective electrode 117 (or reflection portion 120) is positioned closer to the substrate 110 than to the upper surface of the overcoat layer 113. Therefore, the display apparatus 100 according to Fig. 9 can maximize the light extraction enhancement by increasing the amount of reflection that reflects light emitted from the organic light-emitting layer 116 toward the adjacent subpixel SP. The pattern portion PP according to an example can be provided to have a 'V' shape or a 'U' shape.

Referring to FIG. 9, the pattern portion PP may include a bottom surface PP1 and an inclined surface PP2. The bottom surface PP1 of the pattern portion PP may refer to a portion of the pattern portion PP that is positioned closest to the substrate 110. The inclined surface PP2 of the above pattern portion PP may refer to a portion connected to the bottom surface PP1 and the upper surface of the overcoat layer 113. According to one example, the inclined surface PP2 may be provided to form an obtuse angle with the upper surface of the overcoat layer 113. Accordingly, the display apparatus 100 according to the fifth embodiment of the present disclosure may have a structural feature in which the reflective electrode 117 (or reflective portion 120) disposed on the bottom surface PP1 is disposed closer to the substrate 110 than the pixel electrode 114 in the first subpixel SP1 (or one subpixel SP1). In addition, the display apparatus 100 according to the fifth embodiment of the present disclosure may have a structural feature in which the reflective electrode 117 (or reflective portion 120) disposed on the bottom surface PP1 is disposed closer to the substrate 110 than the pixel electrode 114 in the second subpixel SP2 (or third subpixel SP3). Due to the above features, the display apparatus 100 according to the fifth embodiment of the present disclosure can be provided with a reflective electrode 117 (or reflective portion 120) having a long reflection length (or a large reflection area) in the non-light emission area NEA, so that the light extraction enhancement can be maximized.

The display apparatus according to the present disclosure can improve light extraction efficiency by allowing a reflective electrode included in one of a plurality of subpixels to be partially positioned closer to the substrate than the pixel electrode, so that the reflective electrode can reflect light directed toward an adjacent subpixel to the outside of the substrate.

The display apparatus according to the present disclosure is provided such that an overcoat layer and a color filter (or an upper color filter) included in one of a plurality of subpixels have different refractive indices, so that light extraction efficiency can be maximized through total reflection between the overcoat layer and the color filter (or the upper color filter).

Since the display apparatus according to the present disclosure can extract light in the light emission area and/or the non-light emission area through the difference in refractive indices between the overcoat layer and the color filter (or the upper color filter) and the reflective electrode disposed closer to the substrate than the pixel electrode, the display apparatus can have the same light-emitting efficiency or improve the light-emitting efficiency more than that even at low power compared to the display apparatus having no difference in refractive indices between the overcoat layer and the color filter (or the upper color filter) or no reflective electrode disposed closer to the substrate than the pixel electrode, so that the overall power consumption can be reduced.

## Claims

1. A display apparatus (100) comprising:
a substrate (110) comprising a plurality of pixels having a plurality of subpixels (SP),
wherein a first subpixel (SP1) of the plurality of subpixels (SP) comprises:
an overcoat layer (113) disposed on the substrate (110);
an upper color filter (UCF) on the overcoat layer (113);
a pixel electrode (114) disposed on the upper color filter (UCF); and
a reflective electrode (117) on the pixel electrode (114),
wherein the reflective electrode (117) extends into a non-light emission area (NEA) between the plurality of subpixels (SP),
wherein the reflective electrode (117) in the non-light emission area (NEA) is partially disposed closer to the substrate (110) than the pixel electrode (114), and
wherein a refractive index of the upper color filter (UCF) is different from a refractive index of the overcoat layer (113).

2. The display apparatus (100) of claim 1, wherein the first subpixel (SP1) further includes an organic light-emitting layer (116) between the pixel electrode (114) and the reflective electrode (117), and the organic light-emitting layer (116) is partially in contact with the upper color filter (UCF).

3. The display apparatus (100) of claim 1 or 2, wherein the upper color filter (UCF) comprises:
a flat surface (UCFa) in contact with the pixel electrode (114); and
an inclined surface (UCFb) connected to the flat surface (UCFa) and provided with an incline,
wherein the inclined surface (UCFb) forms an obtuse angle with the flat surface (UCFa).

4. The display apparatus (100) of claim 3, wherein the first subpixel (SP1) further includes a bank (115) covering an edge of the pixel electrode (114) and the inclined surface (UCFb), and the reflective electrode (117) in the non-light emission area (NEA) is disposed on the bank (115).

5. The display apparatus (100) of claim 1, wherein the first subpixel (SP1) further includes a low-temperature inorganic film (130) disposed between the pixel electrode (114) and the upper color filter (UCF).

6. The display apparatus (100) of claim 5, wherein the upper color filter (UCF) comprises:
a flat surface (UCFa) provided parallel to an upper surface of the substrate (110); and
an inclined surface (UCFb) connected to the flat surface (UCFa) and provided with an incline,
wherein the low-temperature inorganic film (130) covers the flat surface (UCFa) and the inclined surface (UCFb).

7. The display apparatus (100) of claim 5 or 6, wherein the plurality of subpixels (SP) further include a second subpixel (SP2) arranged adjacent to the first subpixel (SP1),
wherein the second subpixel (SP2) includes:
an overcoat layer (113) arranged on the substrate (110); and
a pixel electrode (114) arranged on the overcoat layer (113) of the second subpixel (SP2),
wherein the low-temperature inorganic film (130) in the first subpixel (SP1) is arranged to extend to the second subpixel (SP2), and
wherein the low-temperature inorganic film (130) arranged in the second subpixel (SP2) is arranged between the overcoat layer (113) and the pixel electrode (114) of the second subpixel (SP2).

8. The display apparatus (100) of claim 7, wherein the plurality of subpixels (SP) further include a third subpixel (SP3) arranged adjacent to the second subpixel (SP2),
wherein the third subpixel (SP3) includes:
a lower color filter (LCF) arranged on the substrate (110);
an overcoat layer (113) arranged on the lower color filter (LCF); and
a pixel electrode (114) arranged on the overcoat layer (113) of the third subpixel (SP3),
wherein the low-temperature inorganic film (130) in the second subpixel (SP2) is arranged to extend to the third subpixel (SP3), and
wherein the low-temperature inorganic film (130) arranged in the third subpixel (SP3) is arranged between the overcoat layer (113) and the pixel electrode (114) of the third subpixel (SP3).

9. The display apparatus (100) of claim 8, wherein the second subpixel (SP2) further includes a reflective electrode (117), and wherein the reflective electrodes (117) of the first and second subpixels (SP1, SP2) are arranged sequentially, such that the reflective electrode (117) arranged in the first subpixel (SP1) is spaced further from the substrate (110) than the reflective electrode (117) arranged in the second subpixel (SP2),
wherein, preferably:
the third subpixel (SP3) further includes a reflective electrode (117), and the reflective electrode (117) arranged in the second subpixel (SP2) and the reflective electrode (117) arranged in the third subpixel (SP3) are spaced apart from the substrate (110) by substantially the same distance.

10. The display apparatus (100) of claim 5, wherein a width (W1) of the low-temperature inorganic film (130) is narrower than a width of an upper surface of the upper color filter (UCF) and wider than a width of the pixel electrode (114).

11. The display apparatus (100) of claim 10, wherein the low-temperature inorganic film (130) comprises:
an upper surface (131a) partially in contact with a lower surface of the pixel electrode (114); and
a side surface (131b) connected to the upper surface (131a) and provided with an incline,
wherein the side surface (131b) comprises an unevenness (UE).

12. The display apparatus (100) of claim 11, wherein the first subpixel (SP1) further includes an organic light-emitting layer (116) between the pixel electrode (114) and the reflective electrode (117),
wherein the organic light-emitting layer (116) and the reflective electrode (117) are arranged to extend to the side surface (131b) of the low-temperature inorganic film (130) and an inclined surface (UCFb) of the upper color filter (UCF), and
wherein each of the organic light-emitting layer (116) and the reflective electrode (117) arranged on the side surface (131b) of the low-temperature inorganic film (130) includes a dummy unevenness (DUE) provided in a shape corresponding to the unevenness (UE) included in the side surface (131b) of the low-temperature inorganic film (130).

13. The display apparatus (100) of claim 11 or 12, wherein the plurality of subpixels (SP) further include a second subpixel (SP2) arranged adjacent to the first subpixel (SP1),
wherein the second subpixel (SP2) includes:
an overcoat layer (113) arranged on the substrate (110);
a low-temperature inorganic film (132) arranged on the overcoat layer (113) of the second subpixel (SP2); and
a pixel electrode (114) arranged on the low-temperature inorganic film (132) of the second subpixel (SP2),
wherein the low-temperature inorganic film (132) and the pixel electrode (114) of the second subpixel (SP2) are disconnected from the low-temperature inorganic film (130) and the pixel electrode (114) of the first subpixel (SP1), respectively,
wherein, preferably:
a width (W2) of the low-temperature inorganic film (132) of the second subpixel (SP2) is wider than a width of the pixel electrode (114) of the second subpixel (SP2), and
a side surface (132b) of the low-temperature inorganic film (132) of the second subpixel (SP2) includes an unevenness (UE).

14. The display apparatus (100) of claim 13, wherein the plurality of subpixels (SP) further include a third subpixel (SP3) arranged adjacent to the second subpixel (SP2),
wherein the third subpixel (SP3) includes:
a lower color filter (LCF) arranged on the substrate (110);
an overcoat layer (113) arranged on the lower color filter (LCF);
a low-temperature inorganic film (133) arranged on the overcoat layer (113) of the third subpixel (SP3); and
a pixel electrode (114) arranged on the low-temperature inorganic film (133) of the third subpixel (SP3), and
wherein the low-temperature inorganic film (133) and the pixel electrode (114) of the third subpixel (SP3) are disconnected from the low-temperature inorganic film (132) and the pixel electrode (114) of the second subpixel (SP2), respectively,
wherein, preferably:
a width (W3) of the low-temperature inorganic film (133) of the third subpixel (SP3) is wider than a width of the pixel electrode (114) of the third subpixel (SP3), and
a side surface (133b) of the low-temperature inorganic film (133) of the third subpixel (SP3) includes an unevenness (UE).

15. The display apparatus (100) of any of claims 1 to 14, further comprising:
a pattern portion (PP) placed on the substrate (110) and concavely formed in the non-light emission area (NEA),
wherein the reflective electrode (117) of the first subpixel (SP1) extends to the pattern portion (PP) and is formed concavely along a shape of the pattern portion (PP),
wherein, preferably:
the overcoat layer (113) of the first subpixel (SP1) is arranged to extend to the non-light emission area (NEA), and
the pattern portion (PP) is formed by a patterned portion of the overcoat layer (113) of the first subpixel (SP1) arranged in the non-light emission area (NEA); and/or
the pattern portion (PP) includes a bottom surface (PP1) arranged closest to the substrate (110), and
the reflective electrode (117) of the first subpixel (SP1) arranged on the bottom surface (PP1) is arranged closer to the substrate (110) than the pixel electrode (114) in the first subpixel (SP1).
